# EUROPÄISCHE PATENTSCHRIFT

(11) **EP 2 210 115 B1**
(45) Veröffentlichungstag und Bekanntmachung des Hinweises auf die Patenterteilung: **27.06.2012**
(21) Anmeldenummer: 08804890.5
(22) Anmeldetag: 29.09.2008
(51) Int. Cl.: G01R 1/073, G01R 31/28

(54) **VOLLRASTERKASSETTE FÜR EINEN PARALLELTESTER ZUM TESTEN EINER UNBESTÜCKTEN LEITERPLATTE, FEDERKONTAKTSTIFT FÜR EINE SOLCHE VOLLRASTERKASSETTE SOWIE ADAPTER FÜR EINEN PARALLELTESTER ZUM TESTEN EINER UNBESTÜCKTEN LEITERPLATTE**
FULL GRID CARTRIDGE FOR A PARALLEL TESTER FOR TESTING AN UNPOPULATED PRINTED CIRCUIT BOARD, SPRING CONTACT PIN FOR SUCH A FULL GRID CARTRIDGE AND ADAPTER FOR TESTING AN UNPOPULATED PRINTED CIRCUIT BOARD
CASSETTE À GRILLE PLEINE SURFACE POUR UN TESTEUR PARALLÈLE SERVANT À TESTER UN CIRCUIT IMPRIMÉ NU, POINTE DE CONTACT À RESSORT POUR UNE TELLE CASSETTE À GRILLE PLEINE SURFACE ET ADAPTATEUR POUR UN TESTEUR PARALLÈLE SERVANT À TESTER UN CIRCUIT IMPRIMÉ NU

(30) Priorität: 02.10.2007 DE 102007047269
(43) Veröffentlichungstag der Anmeldung: 28.07.2010
(73) Patentinhaber: DTG International GmbH, 8005 Zürich (CH)
(72) Erfinder: GÜLZOW, Andreas, 31832 Springe (DE); DEHMEL, Rüdiger, 31515 Wunstorf (DE)
(74) Vertreter: Ganahl, Bernhard
(86) Internationale Anmeldenummer: PCT/EP2008/063038
(87) Internationale Veröffentlichungsnummer: WO 2009/047160

(56) Entgegenhaltungen:
- DE-A1- 19 900 833
- DE-C1- 19 644 725
- US-A- 5 493 230
- US-B1- 6 292 004
- US-B1- 6 724 207

## Beschreibung

Die Erfindung betrifft eine Vollrasterkassette für einen Paralleltester zum Testen einer unbestückten Leiterplatte, einen Federkontaktstift für eine solche Vollrasterkassette sowie einen Adapter für einen Paralleltester zum Testen einer unbestückten Leiterplatte.

Vorrichtungen zum Testen von Leiterplatten werden in zwei Gruppen unterteilt, den Fingertestern, die mit mehreren Kontaktfingern Prüfpunkte einer zu untersuchenden Leiterplatte seriell abtasten, und den Paralleltestern, die alle Prüfpunkte bzw. Leiterplattentestpunkte einer zu untersuchenden Leiterplatte gleichzeitig mittels eines Adapters kontaktieren. Derartige Adapter werden auch als Rasteranpassungsadapter bezeichnet, da sie ein vorbestimmtes, regelmäßiges Grundraster der Prüfvorrichtung auf die üblicherweise unregelmäßige Anordnung der Leiterplattentestpunkte einer zu testenden Leiterplatte umsetzen. Ein solcher Adapter weist in der Regel mehrere voneinander beabstandete Führungsplatten auf, in welchen Führungslöcher zur Aufnahme von Prüfnadeln eingebracht sind. Die Prüfnadeln können im Adapter schräg angeordnet sein, so dass sie Kontaktpunkte des regelmäßigen Grundrasters mit den Leiterplattentestpunkten elektrisch verbinden können, die in der Regel von der regelmäßigen Anordnung des Grundrasters abweichen.

In der Regel wird der Adapter nicht unmittelbar auf dem Grundraster angeordnet, sondern es wird zwischen dem Grundraster und dem Adapter eine sogenannte Vollrasterkassette vorgesehen. Eine Vollrasterkassette ist ähnlich wie der Adapter aus mehreren Führungsplatten ausgebildet, in welcher Kontaktstifte in dem gleichen Raster wie das Grundraster vorgesehen sind. Diese Kontaktstifte sind federnd ausgebildet. Der Grund, weshalb eine derartige Vollrasterkassette verwendet wird, ist, dass derartige federnden Kontaktstifte in den das Raster des Grundrasters auf die Leiterplattentestpunkte der zu testenden Leiterplatte abbildenden Adapter eingesetzt werden können, da diese zu dick sind, um sie im Adapter schräg anordnen zu können. Andererseits ist es notwendig, dass Höhenunterschiede aufgrund von Unebenheiten in der zu prüfenden Leiterplatte bzw. aufgrund der Schrägstellung der Nadeln im Adapter durch die federnden Kontaktstifte der Vollrasterkassette ausgeglichen werden können.

Eine solche Vollrasterkassette kann integraler Bestandteil der Prüfvorrichtung sein. Die Vollrasterkassette kann jedoch auch ein separat ausgebildetes Bauteil sein, das austauschbar auf dem Grundraster der Prüfvorrichtung anordbar ist.

Für einen zu prüfenden Leiterplattentyp muss jeweils ein spezieller Adapter hergestellt werden. Die Vollrasterkassette ist hingegen unabhängig vom Typ der zu prüfenden Leiterplatte.

Im Adapter können sogenannte Glattnadeln verwendet werden. Das sind dünne, geradlinige Drahtabschnitte mit einer Stärke von 0,1 mm bis 0,2 mm. Da heutzutage fast alle Prüfvorrichtungen zum zweiseitigen Testen einer Leiterplatte ausgebildet sind, sind in einer Prüfvorrichtung sowohl unterhalb der zu testenden Leiterplatte als auch oberhalb der zu testenden Leiterplatte jeweils ein Adapter vorzusehen. Damit die Nadeln nicht aus dem Adapter herausfallen, müssen sie darin fixiert werden. Bei Verwendung derartiger Glattnadeln erfolgt die Fixierung entweder mittels einer gelochten Latex-Folie oder einem Nylongewebe. Die Latex-Folie muss an den Stellen, wo sie von den Nadeln durchstochen wird, vorgebohrt sein. Das Bohren einer derartigen Folie ist sehr aufwendig und schwierig. Die Verwendung eines Gewebes ist wesentlich einfacher, da die Nadeln das Gewebe zwischen den einzelnen Gewebefäden durchstechen können. Jedoch wird hierdurch ein Versatz auf die Nadeln ausgeübt, der bei einer zunehmenden Erhöhung der Dichte der Leiterplattentestpunkte und damit auch der Dichte der Nadeln zu erheblichen Problemen führt.

Aus der EP 149 776 B1 sind Prüfnadeln für einen Adapter bekannt, die an einem Ende einen Kugelkopf aufweisen, der verhindert, dass die Prüfnadeln in den Adapter rutschen. Der darin gezeigte Adapter ist jedoch nur zur Verwendung von Prüfvorrichtungen zum einseitigen Testen von Leiterplatten geeignet, da die Prüfnadeln mit ihrem Kugelkopf immer auf der Oberseite des Adapters angeordnet sein müssen und der Adapter nicht umgedreht werden kann. Dieser Typ von Prüfnadeln wurde dahingehend weiterentwickelt, dass die Nadeln mit einem kugelförmigen Kunststoffkopf versehen werden, der ein kleines Stück vom oberen Ende der Nadeln beabstandet ist. Hierdurch ist es möglich, auf dem Adapter eine weitere Lochplatte anzuordnen, so dass die Kunststoffköpfe der Nadeln zwischen dieser Lochplatte und einer weiteren Führungsplatte fixiert sind. Die derart fixierten Nadeln können nicht mehr aus dem Adapter herausfallen. Jedoch erfordern diese Kunststoffköpfe und die zusätzliche Fixierplatte einen Mindestabstand zwischen den benachbarten Nadeln, so dass diese Art der Fixierung keine weitere Erhöhung der Dichte der Anordnung der Nadeln erlaubt.

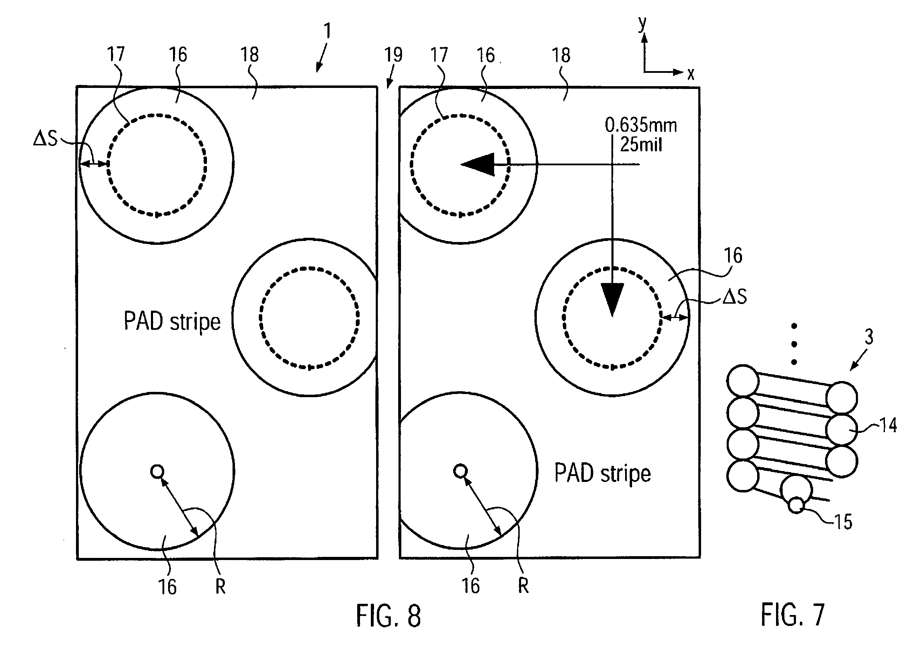

In der noch nicht veröffentlichten deutschen Patentanmeldung DE 10 2006 059 429.0 ist ein Paralleltester zum Testen von unbestückten Leiterplatten beschrieben, dessen Grundraster aus zwei ineinander verschränkten quadratischen Rastern ausgebildet ist. Ein jedes quadratische Raster hat einen Rasterabstand von 50 mil. Die beiden Raster sind jeweils in X- und Y-Richtung um einen halben Rasterabstand (= 25 mil) zueinander versetzt (Figur 8). Ein solches Raster kann auch als ein um 45° schräg gestelltes quadratisches Raster dargestellt werden, wobei der Rasterabstand dieses schräg gestellten quadratischen Rasters etwa 0,89 mm beträgt. Die Dichte der Kontaktstellen am gesamten Grundraster beträgt 124 Kontaktpunkte pro Quadratzentimeter. Da die Leiterplattentestpunkte an den zu prüfenden Leiterplatten unregelmäßig angeordnet sind, gibt es hier Bereiche, in welchen die Dichte nochmals deutlich erhöht ist. So kann z. B. die Dichte in einem Flächenbereich von z. B. 1 cm x 1 cm bis über 600 Leiterplattentestpunkte betragen.

Mit den bekannten Adaptern können lokal sehr enge Abstände zwischen benachbarten Prüfnadeln erzielt werden. So gehen aus der EP 206 704 B1 Prüfnadeln für einen Adapter hervor, die an ihrem freien Ende eine sich konisch verjüngende Kontaktspitze aufweisen. Mit diesen Nadeln können Abstände zwischen benachbarten Kontaktspitzen von 0,25 mm oder kleiner erzielt werden. Jedoch ist es aufgrund der oben erläuterten Fixierungsmethoden (Latex-Folie, Gewebe, Kunststoffköpfe) nicht möglich, in einem vorbestimmten Flächenbereich von zum Beispiel 1 cm x 1 cm eine Vielzahl von Prüfnadeln mit einem derart engen Abstand anzuordnen. Es besteht daher ein erheblicher Bedarf nach einer Vorrichtung zum Kontaktieren einer Leiterplatte, die es erlaubt, Prüfnadeln mit ihren zu der zur testenden Leiterplatte weisenden Enden mit einer Dichte von 600 Prüfnadeln pro cm² anzuordnen.

Die DE 196 44 725 C1 zeigt den grundsätzlichen Aufbau einer Vollrasterkassette beschrieben. In dieser Vollrasterkassette sind Vollrasterstifte gelagert, die jeweils aus einem oberen und einem unteren Stiftabschnitt bestehen, die jeweils über eine Schraubenfeder mit einander elastisch und elektrisch leitend verbunden sind. Die Feder weist einen größeren Durchmesser als die Stiftabschnitte auf. Die jeweiligen Bohrungen zur Aufnahme der Stiftabschnitte und der Feder sind stufig ausgeführt, so dass die Vollrasterstifte verliersicher in der Vollrasterkassette gehalten werden.

In der DE 199 00 833 B4 ist eine Testhalterung zum Halten von bedruckten Leiterplatten in einer Prüfvorrichtung beschrieben. Die Testhalterung weist eine Trägerplatte auf, auf der eine Sondenplatte angeordnet ist. Sowohl in der Trägerplatte 12 als auch in der Sondenplatte sind Bohrungen zum Aufnehmen von Federdrucksonden vorgesehen. Zwischen der Trägerplatte und der Sondenplatte ist eine Sondenhaltefolie angeordnet, durch die sich die Federdrucksonden erstrecken. Die Folie kann aus Gummi mit geschlossenen Zel-len, insbesondere Latex-Gummi, ausgebildet sein.

Die FR 2 887 034 zeigt die Verwendung eines aus einem Draht mit einem schraubenförmig gewickelten Federabschnitt ausgebildeten Federkontaktstift ohne Ummantelung. Dieser Federkontaktstift ist zwischen einem Substrat und einer Lötstelle einer Platine angeordnet. Der zuständige Prüfer hat dieses Dokument bezüglich des neben geordneten Patentanspruchs zitiert.

Der Erfindung liegt deshalb die Aufgabe zu Grunde, eine Vollrasterkassette für einen Paralleltester zum Testen einer unbestückten Leiterplatte zu schaffen, die gegenüber herkömmlichen Vorrichtungen eine bereichsweise höhere Dichte an Kontaktpunkten erlaubt und zudem für den zweiseitigen Test von Leiterplatten geeignet ist.

Die Aufgabe wird durch eine Vollrasterkassette mit dem Merkmal des Anspruchs 1 gelöst. Vorteilhafte Ausgestaltungen der Erfindung sind in den jeweiligen Unteransprüchen angegeben.

Nach der vorliegenden Erfindung ist eine Vollrasterkassette für eine Vorrichtung zum Testen von unbestückten Leiterplatten zum elektrischen Verbinden von Kontaktstellen eines Grundrasters mit jeweils einer Prüfnadel eines Rasteradapters vorgesehen. Sie weist eine zum Grundraster weisend angeordnete Grundrasterplatte und eine zum Adapter weisend angeordnete Adapterplatte auf, in welchen jeweils fluchtende Durchgangsbohrungen zum Aufnehmen von Federkontaktstiften angeordnet sind. Die Federkontaktstifte sind jeweils aus einem Draht mit einem schraubenförmig gewickelten Federabschnitt ausgebildet und ohne Ummantelung in den Durchgangsbohrungen der Adapterplatte und der Grundrasterplatte angeordnet. Die Federabschnitte erstrecken sich zumindest über den Bereich zwischen der Adapterplatte und der Grundrasterplatte. Eine Folie ist zwischen der Adapterplatte und der Grundrasterplatte angeordnet. Die Folie weist Löcher auf, durch die sich jeweils einer der Federkontaktstifte erstreckt, wobei die Breite der Löcher kleiner als der Durchmesser der Federkontaktstifte im Bereich des Federabschnitts ist.

Die Federkontaktstifte sind ohne Ummantelung in den Durchgangsbohrungen der Adapterplatte und der Grundrasterplatte eingesetzt. Hierdurch wird eine höhere Rasterdichte im Vergleich zur Vollrasterkassette mit Kontaktstiften erreicht, bei der die Kontaktstifte eine Hülse aufweisen. Die Federkontaktstifte können somit mit einem maximalen Außendurchmesser von nicht größer als 0,75 mm ausgebildet und in entsprechend große Bohrungen eingesetzt sein. Mit derart kleinen Federkontaktstiften wird an der Vollrasterkassette ein mit zwei verschränkten quadratischen Raster mit einem Rasterabstand von 50 mil (=1,27 mm) erzielt (Fig. 8). Zudem können zwei derartige regelmäßige quadratische Raster um einen halben Rasterabstand zueinander versetzt ausgebildet sein, so dass hier gegenüber dem einfachen quadratischen Raster die doppelte Dichte an Federkontaktstiften erzielt wird.

Weiterhin werden die Federkontaktstifte durch die zwischen der Adapterplatte und der Grundrasterplatte angeordnete Folie im Adapter gehalten und sind gegen ein Herausfallen gesichert. Hierdurch kann der Adapter beim Handhaben mit einer beliebigen Seite nach oben weisend gehalten werden, ohne dass die Federkontaktstifte herausfallen. Dies ist besonders von Vorteil in Verbindung mit einem Adapter, bei dem die Prüfnadel nur gegenüber dem Herausfallen an einer Seite gesichert sind. Die vorliegende Rasterkassette kann auf einen solchen Adapter aufgesetzt werden, so dass vom Adapter die Prüfnadeln gegenüber dem Herausfallen auf beiden Seiten gesichert sind. Eine solche Einheit aus Vollrasterkassette und Adapter kann dann mit einer beliebigen Seite nach oben weisend angeordnet werden und zwei solcher Einheiten können in eine Prüfvorrichtung zum beidseitigen Testen von Leiterplatten eingesetzt werden.

Die Erfinder der vorliegenden Erfindung haben erkannt, dass es wesentlich schwieriger ist, die Prüfnadeln eines Adapters bei der hier erforderlichen Kontaktstellendichte mit einer Folie oder einem Gewebe im Adapter gegen ein Herausfallen zu sichern, als die im Vergleich zu den Prüfnadeln wesentlich dickeren Federkontaktstifte in der Vollrasterkassette gegen ein Herausfallen zu sichern.

Vorzugsweise sind die Löcher in den Folien als Langlöcher ausgebildet, die eine Länge aufweisen, die etwas länger als der Außendurchmesser der Federkontaktstifte im Bereich des Federabschnittes ist und deren Breite ein Stück kleiner als der Außendurchmesser der Federkontaktstifte im Bereich des Federabschnittes und/oder einer Verdickungsstelle ist. Beim Einsetzen der Federkontaktstifte in die Vollrasterkassette werden sie durch die Langlöcher durchgeschoben, wobei die Langlöcher seitlich ausweichen, wenn ein bestimmter Druck an die Federkontaktstifte angelegt wird. Wenn die Federkontaktstifte in der Vollrasterkassette ruhen, schnappen die Längskanten der Langlöcher hinter der Verdickungshauptstelle oder zwischen den Windungen der Federkontaktstifte ein und fixieren so die Federkontaktstifte in der Vollrasterkassette.

Es hat sich gezeigt, dass eine Folie aus Polyimid PI besonders geeignet zum Fixieren der Federkontaktstifte in der Vollrasterkassette ist.

Weiterhin wird die Vollrasterkassette für eine Vorrichtung zum Testen von unbestückten Leiterplatten vorgesehen, die zum elektrischen Verbinden von Kontaktstellen eines Grundrasters mit jeweils einer Prüfnadel eines Rasteradapters ausgebildet ist. Die Vollrasterkassette umfasst
- eine zum Grundraster weisend angeordnete Grundrasterplatte und eine zum Adapter weisend angeordnete Adapterplatte, in welchen jeweils fluchtende Durchgangsbohrungen zum Aufnehmen von Federkontaktstiften angeordnet sind, wobei die Federkontaktstifte jeweils aus einem Draht mit einem schraubenförmig gewickelten Federabschnitt ausgebildet sind und ohne Ummantelung in den Durchgangsbohrungen der Adapterplatte und der Grundrasterplatte angeordnet sind, und
- eine Führungseinrichtung, die zwischen der Adapterplatte und der Grundrasterplatte derart angeordnet ist, dass die Adapterplatte und die Grundrasterplatte in Axialrichtung der Federkontaktstifte relativ zueinander bewegbar sind und in der Ebene quer zur Axialrichtung der Federkontaktstifte ein Bewegungsspiel aufweisen.

Die Federkontaktstifte sind ohne Ummantelung in den Durchgangsbohrungen der Adapterplatte und der Grundrasterplatte eingesetzt. Sie bestehen jeweils aus einem Draht und sind zumindest in einem Federabschnitt schraubenförmig gewickelt. Diese Federkontaktstifte weisen deshalb eine Federwirkung in deren Axialrichtung auf. Da sie keine Ummantelungen in Form einer Hülse oder dergleichen aufweisen, besitzen sie auch eine gewisse Elastizität quer zur Axialrichtung.

Die Adapterplatte und die Grundrasterplatte werden von einer Führungseinrichtung derart geführt, dass sie in Axialrichtung der Federkontaktstifte relativ zueinander bewegbar sind. Diese Führungseinrichtung ist jedoch auch derart ausgebildet, dass quer zur Axialrichtung ein Bewegungsspiel zwischen Adapterplatte und der Grundrasterplatte vorhanden ist. Hierdurch können die Adapterplatte und die Grundrasterplatte auch in Querrichtung zur Axialrichtung der Federkontaktstifte zueinander ausgerichtet werden. Da die einzelnen Federkontaktstifte auch bezüglich ihrer Querrichtung eine Elastizität aufweisen, behindern sie nicht eine relative Verschiebung zwischen der Adapterplatte und der Grundrasterplatte. Diese beiden Platten können somit unabhängig voneinander bezüglich des Grundrasters bzw. bezüglich des Adapters ausgerichtet werden. Bei der hier vorhandenen hohen Kontaktpunktdichte sowohl am Grundraster als auch am Adapter bedeutet dieses Bewegungsspiel einen erheblichen Vorteil, da in einer Prüfvorrichtung, da die Adapter in der Prüfvorrichtung bezüglich eines Rahmens der Prüfvorrichtung exakt justiert sind, so dass es aufgrund der relativen kleinen Kontaktflächen des Grundrasters zu den beim Adapterbau üblichen Toleranzen zu Fehlkontaktierungen kommen kann. Da die Grundrasterplatte bezüglich der Adapterplatte um das Bewegungsspiel frei beweglich ist, kann die Grundrasterplatte exakt auf das entsprechende Grundraster ausgerichtet werden und die vorhandenen Toleranzen ausgeglichen werden.

Das Bewegungsspiel beträgt zweckmäßigerweise einen Bereich 50 µm bis 200 µm und vorzugsweise 80 µm bis 150 µm.

Gemäß einer bevorzugten Ausführungsform weist die Adapterplatte Ausrichtstifte zum Eingreifen in den Adapter auf und die Grundrasterplatte Ausrichtstifte zum Eingreifen in die Grundrasterplatte auf, wobei die Ausrichtstifte der Adapterplatte unabhängig und getrennt von den Ausrichtstiften der Grundrasterplatte ausgebildet sind.

Weiterhin wird ein Federkontaktstift für die Vollrasterkassette vorgesehen, der aus einem Draht schraubenförmig gewickelt ist und zumindest einen Federabschnitt aufweist, wobei der maximale Durchmesser des Federkontaktstiftes nicht größer als 0,8 mm ist. An einem Ende des Federkontaktstiftes ist die endseitige Windung des Drahtes mit einem geringeren Radius als benachbarte Windungen gewickelt, so dass der Draht ein Ende aufweist, das mittig bezüglich der benachbarten Windungen angeordnet ist und eine zentrische Federkontaktstelle bildet.

Ein solcher Federkontaktstift für eine Vollrasterkassette weist eine Mindestlänge von etwa 15 bis. 20 mm auf. Der Draht besitzt etwa eine Stärke von 0,12 mm Der kleinste Durchmesser, mit welchem derartige Federkontaktstifte herkömmlicherweise gewickelt werden, beträgt etwa 0,6 mm. Dies bedeutet, dass der kleinste Wickelradius etwa 0,3 mm beträgt. Kleinere Radien sind schwierig zu wickeln und erfordern hohe Kräfte. Beim erfindungsgemäßen Federkontaktstift ist am einen Ende ein Windungsabschnitt mit einem kleineren Radius als die benachbarte Windung gewickelt. Hierdurch ist das Ende dieses Windungsabschnittes zentrisch bezüglich der benachbarten Windung angeordnet. Das Biegen dieses letzten Windungsabschnittes stellt einen erheblichen Aufwand dar, denn auf diesen Windungsabschnitt müssen wesentlich höhere Kräfte zum Biegen des Drahtes ausgeübt werden als bei den üblichen Windungen. Diese zentrisch angeordnete Kontaktstelle des Federkontaktstiftes wird zum Kontaktieren der Kontaktstellen des Grundrasters verwendet. Durch das zentrische Anordnen der Kontaktstelle bezüglich des Federkontaktstiftes wird eine entsprechende Kontaktfläche auf dem Grundraster bei perfekter Ausrichtung des Federkontaktstiftes auch zentrisch kontaktiert. Bei herkömmlichen Federkontaktstiften, bei welchen die Federkontaktstellen außerhalb des Zentrums angeordnet sind, wird ein Padfeld bei perfekter Ausrichtung des Federkontaktstiftes auch außerhalb ihres Zentrums kontaktiert. Hierdurch kann es bei herkömmlichen Federkontaktstiften bereits durch einen geringen Versatz der Kontaktfläche des Grundrasters bezüglich des Federkontaktstiftes passieren, dass die Federkontaktstelle außerhalb der Kontaktfläche des Grundrasters liegt und kein elektrischer Kontakt hergestellt wird. Mit der zentrisch angeordneten Federkontaktstelle wird die Toleranz erheblich gesteigert und bei kreisförmigen Kontaktflächen beträgt die Toleranz einen vollen Radius der kreisförmigen Kontaktfläche. Diese Federkontaktstifte mit zentrischen Federkontaktstellen sind besonders vorteilhaft bei Grundrastern mit hoher Kontaktstellendichte, da hier die Größe der Kontaktfläche sehr klein ist und bereits geringe Versätze zwischen den Federkontaktstiften und den Kontaktflächen des Grundrasters zu einer Fehlkontaktierung führen können.

Weiterhin wird ein Adapter für eine Vorrichtung zum Testen von unbestückten Leiterplatten vorgesehen. Der Adapter ist zum elektrischen Verbinden von Prüfstiften einer Vollrasterkassette mit Kontaktstellen einer zu testenden Leiterplatte ausgebildet. Der Adapter weist mehrere Führungsplatten auf, in welchen Führungsbohrungen ausgebildet sind, durch die sich Kontaktnadeln oder Kontaktstifte erstrecken, wobei die Kontaktstifte zum Kontaktieren von Durchkontaktierungen der zu testenden Leiterplatten mit einer Prüfspitze ausgebildet sind, die wesentlich breiter als der übrige Kontaktstift ist, und die Kontaktstifte jeweils einen Verriegelungsvorsprung aufweisen. Die zur testenden Leiterplatte weisende Führungsplatte des Adapters weist ein Loch auf, das derart ausgebildet ist, dass der Verriegelungsvorsprung von der Seite der zu testenden Leiterplatte hindurch geführt werden kann, und auf der von der zu testenden Leiterplatte weg weisenden Seite ist eine Verriegelungsausnehmung zur Aufnahme des Verriegelungsvorsprungs angrenzend zum Loch angeordnet.

Gemäß diesem Aspekt der Erfindung wird ein Adapter zum elektrischen Verbinden von Prüfstiften einer Vollrasterkassette mit Kontaktstellen einer zu testenden Leiterplatte vorgesehen. Dieser Adapter weist sowohl Kontaktnadeln als auch Kontaktstifte auf. Die Kontaktnadeln sind zum Kontaktieren von Padfeldern an der Leiterplatte vorgesehen. Die Kontaktnadeln sind dünne geradlinige drahtförmige Elemente, die an dem zur Vollrasterkassette weisenden Ende etwas verdickt bzw. verbreitert sind. Derartige Kontaktnadeln sind bekannt. Die Verbreiterung an einem Ende dient dazu, dass die Kontaktnadeln gegen ein Herausfallen an der zur testenden Leiterplatte weisenden Seite des Adapters gesichert sind. Die Kontaktstifte hingegen weisen an der zur testenden Leiterplatte weisenden Seite eine Prüfspitze auf, die wesentlich breiter als der übrige Kontaktstift ist. Mit dieser Prüfspitze können Durchkontaktierungen an der zu testenden Leiterplatte sicher kontaktiert werden. Diese Kontaktstifte können somit nicht an dem zur Vollrasterkassette weisenden Ende mit einer Verdickung versehen werden, um sie gegen ein Herausfallen auf der zur testenden Leiterplatte weisenden Seite zu sichern. Es wird daher vorgeschlagen, diese Kontaktstifte mit einem Verriegelungsvorsprung zu versehen und die zur testenden Leiterplatte weisende Führungsplatte des Adapters mit einem Schlüsselloch auszubilden. Das Schlüsselloch ist in der Draufsicht T-förmig mit einem "Querbalken" und einem "Stamm" ausgebildet. Der Querbalken ist derart lang, dass der Kontaktstift mit seinem vorzugsweise beidseitigen Verriegelungsvorsprung durch den Querbalken hindurchgeführt werden kann. Der Querbalken befindet sich zudem ein Stück neben der idealen Position des Kontaktstiftes, so dass dieser durch die Führung der weiteren Führungsplatten im Stamm des T-Verbindungschlüsselloches zum liegen kommen. Die Verriegelungsvorsprünge liegen somit auf der das Schlüsselloch enthaltenden Führungsplatte auf und sichern den Kontaktstift gegen ein Herausfallen. Bei einer Weiterbildung ist es auch möglich, eine Ausnehmung auf der das Schlüsselloch enthaltenden Führungsplatte an der von der Leiterplatte wegweisenden Seite derart vorzusehen, dass hierin der Verriegelungsvorsprung aufgenommen wird und der Kontaktstift gegen ein Verdrehen gesichert ist. Bei dieser Ausführungsform muss das Loch, durch das der Verriegelungsstift zusammen mit seinem Verriegelungsvorsprung hindurch geführt werden kann, nicht außerhalb der Idealposition des Kontaktstiftes angeordnet seien. Von der zur testenden Leiterplatte abgewandten Seite dieser Führungsplatte ist angrenzend an dieses Loch eine Ausnehmung vorgesehen, in der der Verriegelungsvorsprung aufgenommen ist. Hierdurch ist der Kontaktstift gegen ein Verdrehen gesichert und liegt mit dem Verriegelungsvorsprung auf dieser Führungsplatte auf, so dass er auch gegen ein Herausfallen auf der zur testenden Leiterplatte weisenden Seite gesichert ist.

Wird ein solcher Adapter an eine Vollrasterkassette angesetzt, so können die Kontaktnadeln und Kontaktstifte des Adapters nicht mehr auf der Seite der Vollrasterkassette aus dem Adapter herausfallen. Andererseits sind die Kontaktnadeln durch ihre Verbreiterung und die Kontaktstifte durch ihre Verriegelungsvorsprünge gegen ein Herausfallen auf der von der Vollrasterkassette weg weisenden Seite des Adapters gesichert. Diese Einheit aus Adapter und Vollrasterkassette kann somit beim Handhaben mit einer beliebigen Seite nach unten angeordnet werden, ohne dass eine Kontaktnadel oder ein Kontaktstift herausfallen kann.

Die Erfindung wird nachfolgend anhand der Zeichnungen näher erläutert. In den Zeichnungen zeigen:

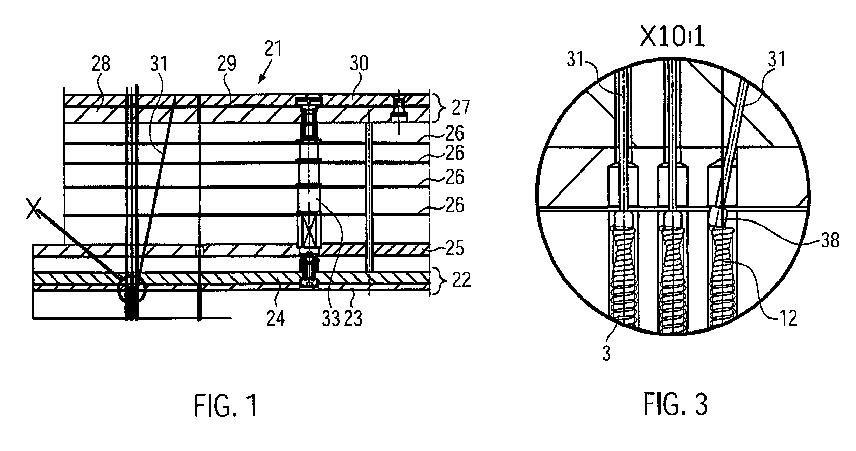

Figur 1 einen Bereich eines Adapters in einer Schnittdarstellung zum Sammeln mit einem angrenzenden Abschnitt einer Vollrasterkassette,
Figur 2 einen Bereich der Vollrasterkassette aus Figur 1 zusammen mit einem Abschnitt des Adapters in einer Schnittdarstellung,
Figur 3 einen Ausschnitt des Kontaktbereiches zwischen Kontaktnadeln des Adapters und Federkontaktstiften der Vollrasterkassette,
Figur 4a und Figur 4b schematisch einen Schnitt durch einen Bereich der Vollrasterkassette und eines Adapters im unbelasteten Zustand (Figur 4a) und im belasteten Zustand (Figur 4b),
Figur 5 schematisch unterschiedliche Kontaktnadel und Kontaktstifte des Adapters zusammen mit einer zu testenden Leiterplatte,
Figur 6a schematisch einen Kontaktstift des Adapters mit Verriegelungsvorsprung und einigen Führungsplatten des Adapters,
Figur 6b schematisch einen Ausschnitt einer Führungsplatte mit einem Loch zur Aufnahme des Kontaktstiftes aus Figur 6a
Figur 7 schematisch einen Endabschnitt eines Federkontaktstiftes mit zentrischer Federkontaktstelle, und
Figur 8 einen Ausschnitt eines Grundrasters, das aus Modulen aufgebaut ist, in der Draufsicht.

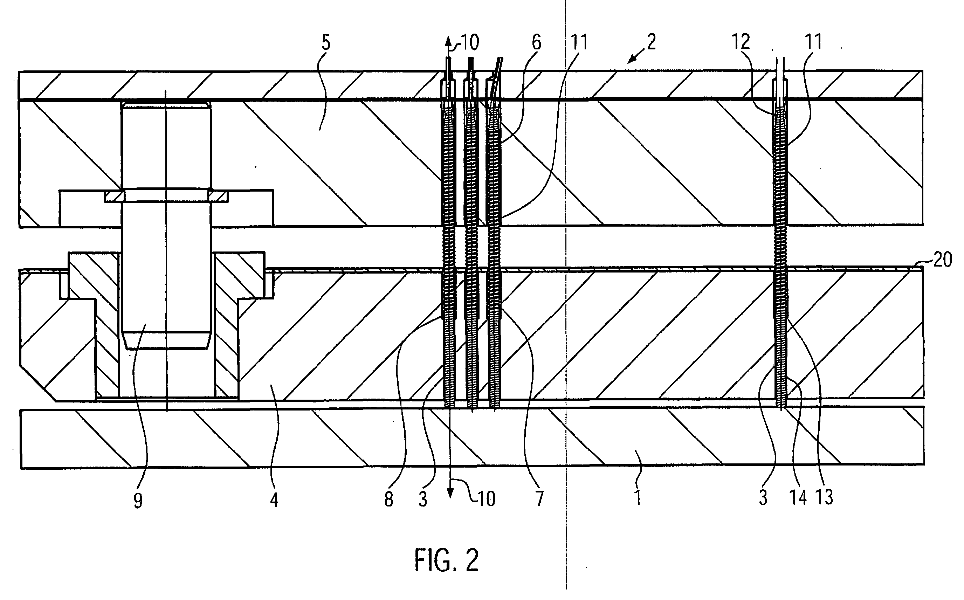

Ein Paralleltester weist ein plattenförmiges Grundrasterelement 1 auf (Figur 2), das eine Vielzahl von Kontaktstellen in Form von Kontaktflächen besitzt, die in einem regelmäßigen Raster angeordnet sind. Diese Kontaktstellen der Grundrasterplatte 1 sind jeweils mit einem Anschluss einer Auswerteelektronik verbunden. Auf der Grundrasterplatte 1 ist eine Vollrasterkassette 2 angeordnet, die Federkontaktstifte 3 aufweist. Die Federkontaktstifte 3 der Vollrasterkassette 2 sind im gleichen Raster wie die Kontaktstellen der Grundrasterplatte 1 angeordnet, so dass jede Kontaktstelle der Grundrasterplatte 1 einen Federkontaktstift 3 berührt und elektrisch kontaktiert wird. Die Federkontaktstifte 3 sind parallel zueinander angeordnet.

Im vorliegenden Ausführungsbeispiel weist die Vollrasterkassette 2 eine Grundrasterplatte 4 und eine Adapterplatte 5 auf. Beide Platten 4, 5 besitzen eine Dicke von 7 mm. In der Adapterplatte 5 sind Durchgangsbohrungen 6 mit konstantem Querschnitt zur Aufnahme jeweils eines Federkontaktstiftes 3 ausgebildet. Der Durchmesser der Durchgangsbohrungen 6 beträgt etwa 0,75 mm.

In der Grundrasterplatte 4 sind auch Durchgangsbohrungen 7 angebracht. Diese Durchgangsbohrungen 7 weisen eine Ringstufe 8 auf, wobei der Durchmesser der Durchgangsbohrung 7 in den Abschnitt zwischen der Ringstufe und der zur Adapterplatte 5 weisenden Seite der Grundrasterplatte 4 dem Durchmesser der Durchgangsbohrungen 6 der Adapterplatte 5 entspricht und in dem Abschnitt von der Ringstufe 8 zu der zur Grundrasterplatte 1 weisenden Seite der Grundrasterplatte 4 etwas kleiner ist und zum Beispiel 0,6 mm beträgt.

Am Randbereich der beiden Platten 4, 5 sind mehrere Führungseinrichtungen 9 angeordnet. Die Führungseinrichtungen 9 sind jeweils aus zwei zueinander verschieblichen Zylinderhülsen ausgebildet, in welchen eine Schraubenfeder (nicht dargestellt) angeordnet ist. Die Führungseinrichtungen 9 sind kraft- und/oder formschlüssig mit den Platten 4, 5 verbunden. Die entsprechenden Bohrungen der Grundrasterplatte 4 und der Adapterplatte 5 sind so angeordnet, dass sie die beiden Platten 4, 5 ein Stück elastisch auseinander drücken. Wird die Vollrasterkassette 2 nicht von außen mit einem Druck belastet, so ergibt sich aufgrund der Führungseinrichtungen 9 ein Abstand zwischen den beiden Platten 4, 5 von etwa 2 bis 5 mm. Die Führungseinrichtungen 9 dienen somit dazu, die beiden Platten 4, 5 bei Belastung derart zu führen, dass sie im wesentlichen nur in Axialrichtung 10 der Federkontaktstifte 3 aufeinander zu bewegt werden.

Die Führungseinrichtungen 9 sind jedoch derart an den beiden Platten 4, 5 angeordnet bzw. ausgebildet, dass quer zur Axialrichtung 10 ein Bewegungsspiel zwischen der Grundrasterplatte 4 und der Adapterplatte 5 besteht. Die Federkontaktstifte 3 sind aus einem Draht mit einer Stärke von z.B. 0,12 mm gewickelt. Sie weisen einen Federabschnitt 11 auf, der sich über ein Großteil der Länge der Federkontaktstifte 3 erstreckt. Im Federabschnitt 11 sind die Federkontaktstifte 3 schraubenförmig gewickelt, wobei benachbarte Windungen zueinander beabstandet ausgebildet sind, so dass diese Federabschnitte eine elastische Federwirkung bereitstellen.

Der Federabschnitt 11 geht an dem zum Adapter weisenden Ende in einen sogenannten Trompetenabschnitt 12 über. Der Trompetenabschnitt 12 weist einige wenige Windungen auf, die ohne axialen Abstand ausgebildet sind. Somit ist der Trompetenabschnitt 12 starr. Er weist eine Verjüngung auf, die sich zum Ende hin wieder aufweitet. Hierdurch wird eine zum Adapter weisende Mulde ausgebildet. Diese Mulde dient zur Aufnahme der Enden von Kontaktnadeln bzw. Kontaktstiften des Adapters. Durch die Verjüngung hat der Trompetenabschnitt die Form einer Trompete, weshalb er auch so bezeichnet wird. Die Anmelderin bezeichnet derartige Federkontaktstifte mit Trompetenabschnitt auch als "Trompetenfedern".

An dem vom Trompetenabschnitt 12 entfernten Ende des Federabschnittes 11 geht der Federabschnitt 11 in eine Verdickungsstelle 13 über, die aus wenigen Windungen mit größerem Durchmesser als alle übrigen Windungen des Federkontaktstiftes 3 ausgebildet ist.

An die Verdickungsstelle 13 schließt sich ein Steckabschnitt 14 des Federkontaktstiftes 3 an. Im Steckabschnitt 14 besitzen die einzelnen Windungen jedoch einen kleineren Durchmesser als die Windungen des Federabschnittes 11 und sind ohne Abstand zueinander angeordnet, so dass der Steckabschnitt 14 steif ist. Am zur Grundrasterplatte 1 weisenden Ende des Steckabschnittes 14 ist der Federkontaktstift 3 etwas verjüngt ausgebildet, wobei der letzte Windungsabschnitt mit einem kleineren Radius als die benachbarten Windungen gebogen ist, so dass der Draht des Federkontaktstiftes 3 ein Ende aufweist, das etwa mittig bezüglich der benachbarten Windungen angeordnet ist. Hierdurch wird eine zentrische Federkontaktstelle 15 ausgebildet (Figur 2, Figur 8).

Figur 8 zeigt in der Draufsicht einen Ausschnitt eines Grundrasters mit kreisförmigen Kontaktfeldern 16. Dieses Grundraster sind zwei ineinander verschränkte quadratische Raster. Ein jedes quadratisches Raster hat einen Rasterabstand von 50 mil. Die beiden Raster sind jeweils in X- und Y-Richtung um einen halben Rasterabstand (= 25 mil) zueinander versetzt.

Bei herkömmlichen Federkontaktstiften liegt die Kontaktstelle außerhalb des Zentrums des Federkontaktstiftes auf einer Kreislinie, die in Figur 8 schematisch durch die Kreislinie 17 angedeutet ist. Bei einer nicht exakt mittigen Ausrichtung des Federkontaktstiftes bezüglich des entsprechenden Kontaktfeldes besteht die Gefahr, dass der Federkontaktstift das Grundrasterelement außerhalb der Kontaktstelle kontaktiert, wodurch kein elektrischer Kontakt erzeugt werden würde. Bei einer exzentrischen Anordnung der Kontaktstelle kann eine Fehlkontaktierung bereits bei einem Versatz um den Abstand zwischen der Kreislinie 17 und dem äußeren Rand des Kontaktfeldes 16 (= Δ s) verursacht werden.

Bei einer zentrischen Anordnung der Federkontaktstelle 15 an dem Federkontaktstift 3 kontaktiert der Federkontaktstift 3 bei perfekter Ausrichtung ein Kontaktfeld 16 exakt im Zentrum. Die Toleranz, ab der die Gefahr einer Fehlkontaktierung besteht, beträgt damit den vollen Radius R des entsprechenden Kontaktfeldes 16 und ist damit um ein Vielfaches größer als die Toleranz Δs bei exakter Anordnung herkömmlicher Federkontaktstifte.

Dies ist insbesondere von Vorteil, wenn das Grundraster aus mehreren Modulen 18 ausgebildet ist. Zwischen den Modulen befinden sich jeweils Stoßkanten 19. Im Bereich der Stoßkanten 19 der Module sind aus fertigungstechnischen Gründen die Kontaktfelder 16 etwas abgeschnitten, so dass hier die Toleranz für einen Versatz der Federkontaktstifte bezüglich der Kontaktfeder 16 nochmals verringert wird. Im Bereich der Stoßkanten 19 ist die Gefahr einer Fehlkontaktierung mit einer exzentrischen Kontaktstelle nochmals wesentlich größer.

Die in Figur 8 gezeigten Kontaktfelder weise einen Durchmesser D von 0,635 mm bzw. einen Radius von 0,317 mm auf. Die optimal erreichbare Toleranz beträgtsomit 0,317 mm. Bei herkömmlichen Federstiften hat die Kreislinie 17 einen Durchmesser von 0,4 mm (r=0,2 mm). Die Toleranz beträgt hier nur noch 0,117 mm. Wenn die Kontaktfelder 16 an den Stoßkanten abgeschnitten sind, dann reduziert sich die Toleranz auf 0,06 mm.

Im Bereich zwischen der Grundrasterplatte 4 und der Adapterplatte 5 befindet sich eine Folie 20. Es ist eine dünne Kunststofffolie, die im Raster der Federkontaktstifte 3 mit Löchern versehen ist. Diese Löcher sind vorzugsweise Langlöcher, deren Länge etwa dem Außendurchmesser der Federkontaktstifte im Bereich des Federabschnittes 11 entspricht oder etwas größer ist und deren Breite etwas kleiner als die maximale Dicke der Federkontaktstifte ausgebildet ist.

Beim Einführen der Federkontaktstifte in die Vollrasterkassette werden die Löcher der Folie 20, insbesondere beim Durchtritt der Verdickungsstelle 13, kurzzeitig elastisch aufgeweitet und die Längskanten des Langloches biegen sich nach außen. Ist der Federkontaktstift in seiner Endposition angelangt, dann schnappen die Längskanten des Langloches zurück und hinter der Verdickungsstelle und/oder in den Zwischenraum zwischen zwei Windungen ein. Hierdurch wird der Federkontaktstift 3 gegen ein Herausfallen aus der Vollrasterkassette gesichert. Insbesondere genügt die Gewichtskraft der Federkontaktstifte 3 nicht, diese mit ihrer Verdickungsstelle 13 durch das entsprechende Langloch hindurchzudrücken.

Im vorliegenden Ausführungsbeispiel ist die Folie aus Polyimid (PI) ausgebildet.

Die Grundrasterplatte 4 und die Adapterplatte 5 sind aus einem faserfreien Kunststoffmaterial ausgebildet. Hierdurch erhalten die Durchgangsbohrungen 6, 7 eine glatte Oberfläche, die das Einführen der Federkontaktstifte erleichtert. Ein geeignetes Kunststoffmaterial ist z.B. Polyetheretherketon (PEEK) im vorliegenden Ausführungsbeispiel weisen die beiden Platten 4, 5 eine Dicke von 7 mm auf. Plattendicken von 5 bis 10 mm sind sinnvoll.

Die elektrische Verbindung zwischen den im regelmäßigen Raster angeordneten Federkontaktstiften und den unregelmäßig angeordneten Kontaktstellen einer zu testenden Leiterplatte, die im folgenden als Leiterplattentestpunkte bezeichnet werden, wird über einen Adapter 21 hergestellt. Der Adapter 21 ist aus mehreren parallel zueinander angeordneten Führungsplatten ausgebildet. Benachbart zur Vollrasterkassette 2 ist ein Plattenpaket mit zwei Platten angeordnet, das Bohrungen im Muster der Anordnung der Federkontaktstifte der Vollrasterkassette bzw. der Kontaktstellen des Grundrasters aufweist. Dieses Plattenpaket wir im folgenden als Grundraster-Einheit 22 bzw. GR-Einheit 22 bezeichnet. Die GR-Einheit 22 ist aus einer Deckplatte 23 und einer Strukturplatte 24 zusammengesetzt. Die Deckplatte ist unmittelbar angrenzend zur Vollrasterkassette 2 angeordnet und weist eine Dicke von 1,5 mm auf. Die Strukturplatte 24 liegt an der Deckplatte 23 an. Sie weist eine Dicke von 3 mm auf und verleiht dem Adapter an der zur Vollrasterkassette weisenden Seite die notwendige mechanische Festigkeit.

Mit etwas Abstand zur Strukturplatte 24 ist eine Halteplatte 25 angeordnet. Die Halteplatte weist eine Stärke von 3 mm auf.

Vier dünne Führungsplatten 26 sind mit Abstand zueinander angeordnet. Sie weisen jeweils eine Dicke von 0,3 mm auf. An der zur Leiterplatte weisenden Seite des Adapters 21 ist eine Platteneinheit mit drei Platten vorgesehen, die im folgenden als Leiterplatteneinheit bzw. LP-Einheit 27 bezeichnet wird. Die LP-Einheit ist aus einer Strukturplatte 28, einer Führungsplatte 29 und einer Deckplatte 30 zusammengesetzt. Die Strukturplatte 28 verleiht der LP-Einheit 27 die notwendige mechanische Festigkeit. Diese Strukturplatte ist mit einer Dicke von 4 mm ausgebildet.

Die Deckplatte 23 und die Deckplatte 30 sind außerhalb des Testfeldes mit den übrigen Platten des Adapters verschraubt. Diese Schraubverbindungen können somit nicht die elektrischen Eigenschaften des Adapters beeinflussen.

Die Führungsplatte 29 ist wiederum eine dünne Führungsplatte mit einer Dicke von 0,3 mm. In einer derart dünnen Platte können die Bohrungen zum Führen der Kontaktnadeln und Kontaktstifte einfacher mit einer hohen Präzision als in den dicken Struktur- und Halteplatten eingebracht werden. Die Führungsplatte 29 weist ein Bohrmuster auf, das dem Muster der Leiterplattentestpunkte entspricht und stellt somit sicher, dass die Prüfnadeln des Adapters 21 exakt auf die Leiterplattentestpunkte ausgerichtet sind.

Alle Platten mit Ausnahme der Deckplatten 23, 30 werden von mehreren an sich bekannten Säulenmechanismen 33 auf Abstand gehalten. Zwischen der GR-Einheit 22 und der LP-Einheit 27 erstrecken sich Ausrichtstifte 34, die jeweils ein Loch in der Halteplatte 25 und den Führungsplatten 26 formschlüssig durchgreifen, so dass die Platten 25, 26 exakt zueinander ausgerichtet sind.

Der Adapter 21 kann als Prüfnadeln sowohl Kontaktnadeln 31 als auch Kontaktstifte 32 aufweisen. Die Kontaktnadeln 31 dienen zum Kontaktieren von Padfeldern auf der zu testenden Leiterplatte. Die Kontaktstifte 32 sind zum Kontaktieren von Durchkontaktierungen 37 der Leiterplatte 35 vorgesehen.

Die Kontaktnadeln 31 können mit unterschiedlichen Durchmessern ausgebildet sein. Im vorliegenden Ausführungsbeispiel sind Kontaktnadeln mit einem Durchmesser von 0,15 mm und Kontaktnadeln 31.2 mit einem Durchmesser von 0,25 mm vorgesehen. Diese Kontaktnadeln 31 weisen jeweils einen kreisförmigen Querschnitt auf. Sie sind an ihren zur Vollrasterkassette weisenden Enden jeweils mit einer Verdickung 38 versehen. Diese Verdickung 38 kann einerseits durch eine aufgesteckte bzw. aufgeschrumpfte Hülse 38.1 oder durch eine Quetschung 38.2 der Kontaktnadel 31.2 ausgebildet sein. Eine Quetschung ist einfacher und kostengünstiger herstellbar. Sie erfordert jedoch eine gewisse Materialstärke der Kontaktnadel und ist vor allem für dickere Kontaktnadeln geeignet. Bei dünneren Kontaktnadeln ist es zweckmäßiger eine zusätzliche Hülse 38.1 vorzusehen.

In der Deckplatte 23 sind Stufenbohrungen zur Aufnahme der Quetschungen 38.2 der Kontaktnadeln 31.2 und in der Halteplatte 25 sind Stufenbohrungen zur Aufnahme der Hülsen 38.1 vorgesehen. Diese Stufenbohrungen dienen jeweils dazu, dass die Kontaktnadeln 31 mit ihrer Verdickung 38 nicht durch die jeweilige Platte 23, 25 hindurchbewegt werden können und somit gegen ein Herausfallen in Richtung zur Seite der zu testenden Leiterplatte gesichert sind.

Mit derartigen Kontaktnadeln 31 ist es grundsätzlich auch möglich, auf der Oberfläche der Leiterplatte 35 befindlichen Randbereiche der Durchkontaktierungen 37 zu kontaktieren. Jedoch hat die Erfahrung gezeigt, dass die Versätze von Padfeldern 36 und Durchkontaktierungen 37 aufgrund der unterschiedlichen Fertigungsverfahren von einander unabhängig sind. Dies heißt, dass in der Regel alle Padfelder 36 einen bestimmten Versatz bezüglich ihrer Idealposition um einen vorbestimmten Betrag und eine vorbestimmte Richtung aufweisen und alle Durchkontaktierungen einen anderen Versatz um eine vorbestimmte Richtung und einen vorbestimmten Betrag aufweisen. Die Kontaktnadeln 31 sind sehr präzise auf die kleinen Padfelder 36 auszurichten und zu justieren.

Die speziell zum Kontaktieren der Durchkontaktierungen 37 ausgebildeten Kontaktstifte 32 besitzen an ihren zur Leiterplatte 35 weisenden Enden einen verbreiterten Tastkopf 39. Dieser Tastkopf 39 ist mit einer zur Leiterplatte 35 weisenden dreieckförmigen Spitze ausgebildet. Hierdurch ist es möglich, die Durchkontaktierung 37 sicher zu kontaktieren, auch wenn die Kontaktstifte 32 bezüglich der Durchkontaktierungen 37 nicht mit der Präzision ausgerichtet sind, mit der die Kontaktnadeln 31 bezüglich der Padfelder 36 ausgerichtet sind. Somit ist es möglich, eine sichere Kontaktierung aller Leiterplattentestpunkt 36, 37 zu erzielen, auch wenn die Ausrichtung des Adapters 21 bzgl. der Leiterplatte 35 vor allem bezüglich der Kontaktnadeln 31 und der entsprechenden Padfelder 36 erfolgt.

Die Kontaktstifte 32 gemäß dem vorliegenden Ausführungsbeispiel sind aus einem dünnen Blech mit einer Dicke von z.B. 0,2 mm gefertigt. Auch die Tastköpfe 39 sind ebenflächig aus dem Blech ausgebildet.

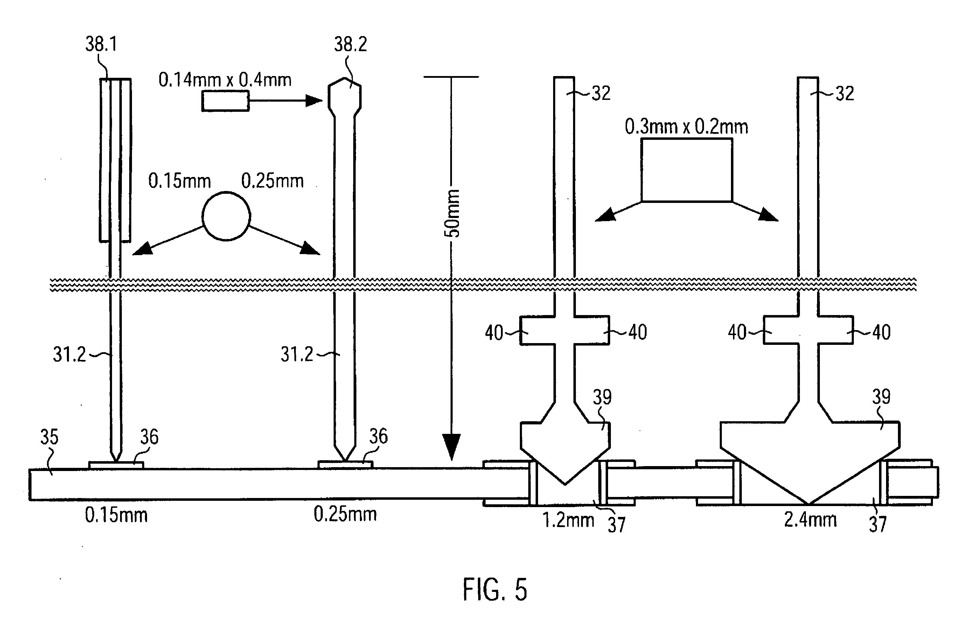

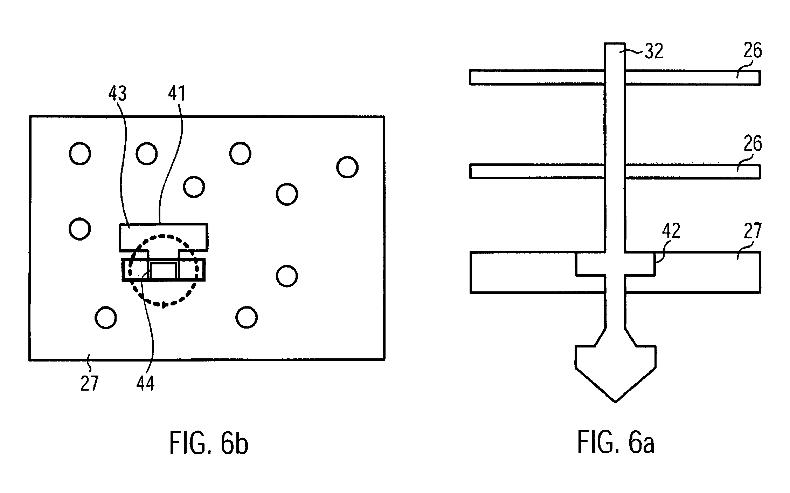

Mit geringfügigem Abstand benachbart zu den Tastköpfen 39 sind an den Kontaktstiften 32 Verriegelungsvorsprünge 40 vorgesehen (Figur 5, 6a).

Zur Aufnahme der Kontaktstifte 32 sind in der LP-Einheit 27 spezielle Löcher eingebracht, die im folgenden als Schlüssellöcher 41 bezeichnet werden. Diese Schlüssellöcher weisen eine Größe auf, dass man den Kontaktstift 32 zusammen mit seinem Verriegelungsvorsprung 40 bzw. seinen Verriegelungsvorsprüngen 40 hindurchführen kann. Angrenzend zum Schlüsselloch 41 kann auf der von der Leiterplatte weg weisenden Seite der LP-Einheit 27 eine Ausnehmung 42 zur Aufnahme des Verriegelungsvorsprunges 40 ausgebildet sein. Bei dem in Figur 6b dargestellten Ausführungsbeispiel ist das Schlüsselloch 41 in der Draufsicht T-förmig ausgebildet, so dass der Kontaktstift zusammen mit seinem Verriegelungsvorsprung 40 durch den "Querbalken 43 des T" hindurchgeführt werden kann, wobei er danach mit dem schmalen Abschnitt des Kontaktstiftes 32 im Bereich zwischen dem Verriegelungsvorsprung 40 und dem Tastkopf 39 entlang dem "Stamm 44 des T" verschoben wird. An dem vom Querbalken 43 entfernten Ende des Stammes 44 ist angrenzend die Ausnehmung 42 zur Aufnahme des Vorriegelungsvorsprunges 40 angeordnet. In diese Ausnehmung 42 wird der Verriegelungsvorsprung eingesetzt, so dass der Kontaktstift daran gehindert ist, sich zurück zum Querbalken 43 zu bewegen und er an der zur Leiterplatte weisenden Seite nicht aus dem Adapter 21 fallen kann.

Die Ausnehmung 40 ist in der Strukturplatte 28 der LP-Einheit 27 ausgebildet.

Im Rahmen der Erfindung kann das Schlüsselloch 41 und die Ausnehmung 42 selbstverständlich auch andere Formen aufweisen. So kann das Schlüsselloch 41 als Langloch ausgebildet sein und die Ausnehmung 42 in der Draufsicht senkrecht zum Langloch verlaufen. Der Kontaktstift 32 ist dann nach dem Hindurchführen des bzw. der Verriegelungsvorsprünge 40 im Schlüsselloch 41 um 90° zu drehen, so dass die Verriegelungsvorsprünge 40 in der Ausnehmung zum Liegen kommen.
Das Schlüsselloch 41 kann auch ohne entsprechende Ausnehmung ausgebildet sein. Die Führungslöcher in den weiteren Führungsplatten 26 sind dabei derart angeordnet, dass sie den Kontaktstift 32 derart führen, dass er durch das Schlüsselloch 41 an einer Stelle tritt, die so schmal ist, dass der bzw. die Verriegelungsvorsprünge 40 auf der Führungsplatte 27 aufliegen. Bei dem in Figur 6b gezeigten T-förmigen Schlüsselloch ist diese Position, die die Idealposition des Kontaktstiftes 32 darstellt, im Bereich des Stammes 44. Zum Einführen bzw. Herausnehmen muss der Kontaktstift 32 gebogen werden, um die Verriegelungsvorsprünge 40 durch den Balken 43 durch das T-förmige Schlüsselloch 41 zu führen.

Die Kontaktstifte 32 im Adapter 21 sind im wesentlichen senkrecht zu den einzelnen Platten 23 - 30 ausgerichtet. Die Kontaktnadeln 31 hingegen werden vielfach schräg verlaufend im Adapter 21 angeordnet. Hierdurch ist es möglich, die nicht im Raster angeordneten Kontaktstellen der zu testenden Leiterplatte zu kontaktieren und in lokal begrenzten Bereichen auf der Seite der zu testenden Leiterplatte viele Kontaktnadeln 31 mit ihren Enden anzuordnen, um eine hohe Kontaktdichte bereitzustellen. Auf der gegenüberliegenden zur Vollrasterkassette 2 weisenden Seite sind die Enden dieser Kontaktnadeln über einen wesentlich größeren Bereich verteilt, in dem sie eine Vielzahl von Federkontaktstiften 3 kontaktieren. Es besteht daher der Wunsch, die Kontaktnadeln 31 möglichst schräg anzuordnen. Der Schrägstellung der Kontaktnadeln 1 sind mechanisch prinzipiell keine Grenzen gesetzt. Jedoch verursacht eine jede Schrägstellung einer Kontaktnadel 31 eine Verkürzung in Axialrichtung, wobei als Axialrichtung die Richtung senkrecht zu den Platten 23 - 30 verstanden wird. Diese Längendifferenz in Axialrichtung wird durch die Federkontaktstifte 3 ausgeglichen.

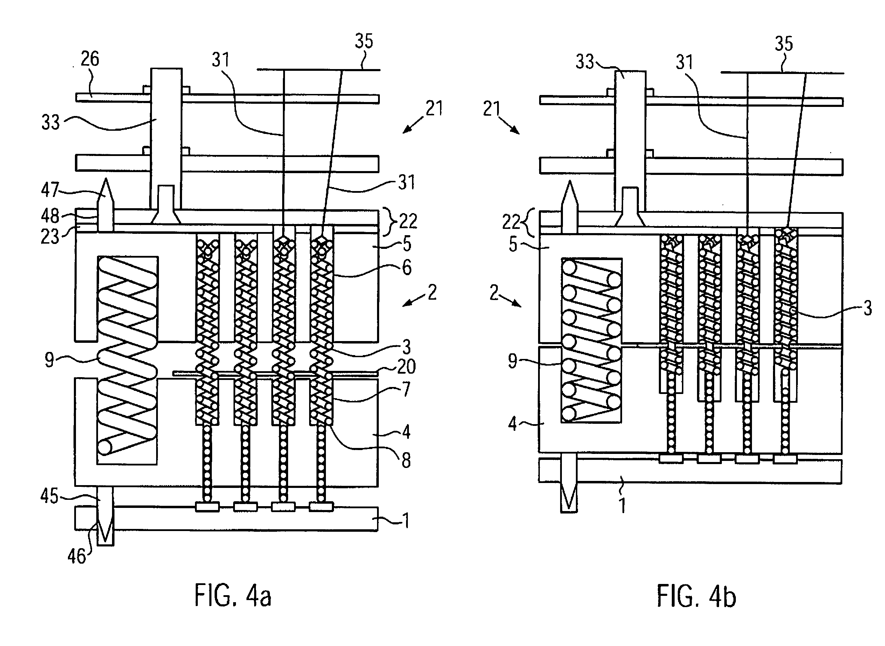

In Figur 4a ist sehr grob schematisch vereinfacht die Vollrasterkassette 2 und der Adapter 21 im unbelasteten Zustand dargestellt. Das heißt, dass die Grundrasterplatte 4 und die Adapterplatte 5 durch die Führungseinrichtung 9 ein Stück auseinander gedrückt sind und die Federkontaktstifte 3 entspannt in den Durchgangsbohrungen 6, 7 lagern. Die Grundrasterplatte 4 ist mit mehreren Ausrichtstiften 45 versehen und mit Ausrichtbohrungen 46 des Grundrasterelements in Eingriff. Die Adapterplatte 5 steht mit Ausrichtstiften 47 mit entsprechenden Ausrichtbohrungen 48 in der GR-Einheit 22 in Eingriff. Die Kontaktnadeln 31 sind mit ihren Verdickungen in den Mulden der Trompetenabschnitte 12 der entsprechenden Federkontaktstifte 3 aufgenommen. Die schräg gestellten Kontaktnadeln 31 sind mit Abstand zu der zu testenden Leiterplatte 35 angeordnet.

Wird nun diese Kontaktanordnung belastet, das heißt durch eine entsprechende Presse zusammengedrückt, so werden in der Vollrasterkassette 2 die Grundrasterplatte 4 und die Adapterplatte 5 entgegen der Federwirkung der Führungseinrichtungen 9 zusammengedrückt. Hierdurch werden die Federkontaktstifte 3 in Richtung zum Adapter 21 gedrückt. Sie liegen dann mit Federspannung an den Kontaktnadeln 31 an. Die Kontaktnadeln 31 werden dann in Richtung zur testenden Leiterplatte 35 gedrückt, so dass alle Kontaktnadeln 31 die entsprechenden Leiterplattentestpunkte kontaktieren. In Figur 4b kann man gut die unterschiedlichen Niveaus der Berührungsstellen zwischen Kontaktnadeln und Federkontaktstiften sehen, die schräg gestellt bzw. nicht schräg gestellt sind.

Die Federkontaktstifte 3, denen keine Kontaktnadel 31 bzw. kein Kontaktstift 32 zugeordnet ist, werden gegen die Deckplatte 23 des Adapters 21 gedrückt. Die Deckplatte 23 deckt zudem auch die Schraubenelemente ab, mit welchen die Säulenmechanismen 33 im Adapter befestigt sind. Die Deckplatte 23 stellt somit sicher, dass keine unerwünschten elektrischen Kontakte zwischen nicht verwendeten Federkontaktstiften 3 und anderen Elementen des Adapters hergestellt werden können.

Weiterhin ist anzumerken, dass die Ausrichtstifte 45 der Grundrasterplatte 4 und die Ausrichtstifte 47 der Adapterplatte 5 voneinander unabhängig sind, so dass die Grundrasterplatte 4 und die Adapterplatte 5 unabhängig voneinander bezüglich des Grundrasterelementes 1 bzw. bezüglich des Adapters 21 ausgerichtet werden können. Diese unabhängige Ausrichtung wird zudem durch das Bewegungsspiel zwischen der Grundrasterplatte 4 und der Adapterplatte 5 ermöglicht. Dieses Bewegungsspiel wird zum Einen durch die Führungseinrichtungen 9 und zum Anderen dadurch realisiert, dass die Federkontaktstifte 3 sich über den Zwischenbereich zwischen der Grundrasterplatte 4 und der Adapterplatte 5 ohne Stahlhülse erstrecken und so in Querrichtung zu ihrer Axialrichtung 10 beweglich sind.

Die Erfindung kann folgendermaßen kurz zusammengefasst werden:
Die Erfindung betrifft eine Vollrasterkassette für einen Paralleltester zum Testen einer unbestückten Leiterplatte, einen Federkontaktstift für eine solche Vollrasterkassette sowie einen Adapter für einen Paralleltester zum Testen einer unbestückten Leiterplatte.

Gemäß einem ersten Aspekt der vorliegenden Erfindung werden Federkontaktstifte in der Vollrasterkassette mittels einer Folie fixiert. Gemäß einem weiteren Aspekt der vorliegenden Erfindung weist die Vollrasterkassette zwei Platten auf, die in Axialrichtung der Federkontaktstifte relativ zueinander bewegbar sind und quer zur Axialrichtung ein Bewegungsspiel aufweisen. Gemäß einem dritten Aspekt der vorliegenden Erfindung sind die Federkontaktstifte mit einer zentrischen Federkontaktstelle ausgebildet. Gemäß einem weiteren Aspekt der vorliegenden Erfindung weist ein Adapter Kontaktstifte auf, die mit einem Tastkopf versehen sind, wobei die Kontaktstifte einen Verriegelungsvorsprung besitzen, mit dem sie an einer Führungsplatte des Adapters gegen ein Herausfallen gesichert sind.

### Bezugszeichenliste

- 1: Grundrasterelement
- 2: Vollrasterkassette
- 3: Federkontaktstift
- 4: Grundrasterplatte
- 5: Adapterplatte
- 6: Durchgangsbohrung der Adapterplatte
- 7: Durchgangsbohrung der Grundrasterplatte
- 8: Ringstufe
- 9: Führungseinrichtung
- 10: Axialrichtung der Federkontaktstifte
- 11: Federabschnitt
- 12: Trompetenabschnitt
- 13: Verdickungsstelle
- 14: Steckabschnitt
- 15: zentrische Federkontaktstelle
- 16: Kontaktfeld des Grundrasters
- 17: Kreislinie
- 18: Modul
- 19: Stoßkante
- 20: Folie
- 21: Adapter
- 22: GR-Einheit
- 23: Deckplatte
- 24: Strukturplatte
- 25: Halteplatte
- 26: Führungsplatte
- 27: LP-Einheit
- 28: Strukturplatte
- 29: Führungsplatte
- 30: Deckplatte
- 31: Kontaktnadel
- 32: Kontaktstift
- 33: Säulenmechanismus
- 34: Ausrichtstift
- 35: Leiterplatte
- 36: Padfeld
- 37: Durchkontaktierung
- 38: Verdickung
- 39: Tastkopf
- 40: Verriegelungsvorsprung
- 41: Schlüsselloch
- 42: Ausnehmung
- 43: Querbalken
- 44: Stamm
- 45: Ausrichtstift
- 46: Ausrichtbohrung
- 47: Ausrichtstift
- 48: Ausrichtbohrung

## Patentansprüche

1. Vollrasterkassette für eine Vorrichtung zum Testen von unbestückten Leiterplatten, wobei die Vollrasterkassette (2) zum elektrischen Verbinden von Kontaktstellen eines Grundrasters (1) mit jeweils einer Prüfnadel eines Adapters (21) vorgesehen ist, wobei die Vollrasterkassette (2) umfasst
- Federkontaktstifte,
- eine zum Grundraster weisend angeordnete Grundrasterplatte (4) und eine zum Adapter (21) weisend angeordnete Adapterplatte (5), in welchen jeweils fluchtende Durchgangsbohrungen (6, 7) zum Aufnehmen der Federkontaktstifte (3) angeordnet sind, wobei die Federkontaktstifte (3) jeweils aus einem Draht mit einem schraubenförmig gewickelten Federabschnitt (11) ausgebildet sind und ohne Ummantelung in den Durchgangsbohrungen (6, 7) der Adapterplatte (5) und der Grundrasterplatte (4) angeordnet sind, und sich die Federabschnitte (11) zumindest über den Bereich zwischen der Adapterplatte und der Grundrasterplatte (4) erstrecken,
**dadurch gekennzeichnet, dass** die Vollrasterkassette umfasst
- eine Folie (20), die zwischen der Adapterplatte (5) und der Grundrasterplatte (4) angeordnet ist und Löcher aufweist, durch die sich jeweils einer der Federkontaktstifte (3) erstreckt, wobei die Breite der Löcher kleiner als ein maximaler Durchmesser der Federkontaktstifte (3) ist.

2. Vollrasterkassette nach Anspruch 1,
**dadurch gekennzeichnet,**
**dass** die Löcher der Folie (20) als Langlöcher ausgebildet sind, deren Länge in etwa dem maximalen Durchmesser der Federkontaktstifte entspricht oder etwas größer ist.

3. Vollrasterkassette nach Anspruch 1 oder 2,
**dadurch gekennzeichnet,**
**dass** die Folie (20) aus Poliemid ausgebildet ist.

4. Vollrasterkassette nach einem der Ansprüche 1 bis 3,
**dadurch gekennzeichnet,**
**dass** die Federkontaktstifte aus Federdraht ausgebildet sind.

5. Vollrasterkassette nach einem der Ansprüche 1 bis 4,
**dadurch gekennzeichnet,**
**dass** in den Durchgangsbohrungen (6, 7) der Grundrasterplatte (4) oder der Adapterplatte (5) eine Verjüngung derart ausgebildet ist, dass sich die jeweilige Durchgangsbohrung (6, 7) in Richtung zur Außenseite der Vollrasterkassette (2) verjüngt und dass die Federkontaktstifte (3) eine Verdickungsstelle (13) aufweisen, die zwischen der Verjüngung und der Folie (20) angeordnet ist.

6. Vollrasterkassette nach Anspruch 5,
**dadurch gekennzeichnet,**
**dass** die Verjüngung als Ringstufe (8) ausgebildet ist.

7. Vollrasterkassette nach einem der Ansprüche 1 bis 6,
**gekennzeichnet durch**,
eine Führungseinrichtung (9), die zwischen der Adapterplatte (5) und der Grundrasterplatte (6) derart angeordnet ist, dass die Adapterplatte (4) und die Grundrasterplatte (6) in Axialrichtung der Federkontaktstifte (3) relativ zueinander bewegbar sind und in der Ebene quer zur Axialrichtung (10) der Federkontaktstifte (3) ein Bewegungsspiel aufweisen.

8. Vollrasterkassette nach einem der Ansprüche 1 bis 7,
**dadurch gekennzeichnet,**
**dass** sich der Federabschnitt (11) der Federkontaktstifte (3) über den Bereich zwischen der Adapterplatte (5) und der Grundrasterplatte (4) erstreckt.

9. Vollrasterkassette nach einem der Ansprüche 1 bis 8,
**dadurch gekennzeichnet,**
**dass** die Federkontaktstifte in einem regelmäßigen Raster angeordnet sind, das dem Grundraster entspricht.

10. Vollrasterkassette, nach einem der Ansprüche 1 bis 9,
**dadurch gekennzeichnet,**
**dass** die Federkontaktstifte (3) einen maximale Durchmesser aufweisen, der nicht größer als 0,8 mm ist, und an einem Ende der Federkontaktstifte (3) die endseitige Windung des Drahtes mit einem geringeren Radius als benachbarte Windungen gewickelt ist, so dass der Draht ein Ende aufweist, das mittig bezüglich der benachbarten Windungen angeordnet ist und eine zentrische Kontaktstelle bildet.

11. Vollrasterkassette nach Anspruch 10,
**dadurch gekennzeichnet,**
**dass** der Draht ein Federdraht ist und vorzugsweise
einen Durchmesser von etwa 0,10 bis 0,15 mm und insbesondere 0,10 bis 0,12 mm aufweist.

12. Einheit umfassend eine Vollrasterkassette nach einem der Ansprüche 1 bis 11 und einen Adapter für eine Vorrichtung zum Testen von unbestückten Leiterplatten, wobei der Adapter (21) zum elektrischen Verbinden von Federkontaktstiften (3) einer Vollrasterkassette (2) mit Kontaktstellen (36, 37) einer zu testenden Leiterplatte (35) vorgesehen ist,
**dadurch gekennzeichnet,**
**dass** der Adapter Prüfnadeln aufweist, die nur gegenüber dem Herausfallen an einer Seite des Adapters gesichert sind, und die Vollrasterkassette an der Seite des Adapters angesetzt ist, an welcher die Prüfnadeln nicht gesichert sind.

13. Einheit nach Anspruch 12,
**dadurch gekennzeichnet,**
**dass** der Adapter (21) Kontaktnadeln und/oder Kontaktstifte sowie mehrere Führungsplatten (23, 25, 26, 28, 29, 30) aufweist, in welchen Führungsbohrungen ausgebildet sind, durch die sich die Kontaktnadeln (31) und/oder die Kontaktstifte (32) erstrecken, wobei die Kontaktstifte (32) zum Kontaktieren von Durchkontaktierungen (37) der zu testenden Leiterplatten mit einem Tastkopf ausgebildet sind, der wesentlich breiter als der übrige Kontaktstift (32) ist, und der Kontaktstift (32) einen Verriegelungsvorsprung (40) aufweist, und die zur testenden Leiterplatte weisende Führungsplatte des Adapters (21) ein Schlüsselloch (41) aufweist, das derart ausgebildet ist, dass der Verriegelungsvorsprung (40) von der Seite der zu testenden Leiterplatte (35) hindurch geführt werden kann, und auf der von der zu testenden Leiterplatte weg weisenden Seite entweder eine Verriegelungsausnehmung (42) zur Aufnahme des Verriegelungsvorsprungs (40) angrenzend zum Schlüsselloch angeordnet ist, oder das Schlüsselloch (41) einen Bereich (43) aufweist, durch den der Verriegelungsvorsprung (40) hindurch geführt werden kann und der ein Stück von der Idealposition des Kontaktstiftes (32) versetzt ist, und einen schmäleren Bereich (44) aufweist, der sich bis zur Idealposition erstreckt, so dass der Kontaktstift (32) durch die Führung der weiteren Führungsplatten seine Idealposition einnimmt und der Verriegelungsvorsprung (4) auf der das Schlüsselloch (41) aufweisenden Führungsplatte aufliegt.

14. Einheit nach Anspruch 13,
**dadurch gekennzeichnet,**
**dass** der Adapter sowohl Kontaktnadeln als auch Kontaktstifte (32) aufweist.

15. Einheit nach Anspruch 16 oder 17,
**dadurch gekennzeichnet,**
**dass** die Kontaktstifte (32) aus einem dünnen Blech ausgebildet sind.

## Claims

1. Full grid cassette for an apparatus for testing non-componented printed circuit boards, the full grid cassette (2) being designed for electrically connecting contact points of a basic grid (1) to individual test needles of an adapter (21), wherein the full grid (2) comprises
- spring contact pins
- a basic grid plate (4) oriented towards the basic grid and an adapter plate (5) oriented towards the adapter (21), wherein aligned through holes (6, 7) are provided to accommodate the spring contact pins (3), each of the spring contact pins (3) being made from a wire with a helically wound spring section (11) and located without sheathing in the through holes (6, 7) of the adapter plate (5) and of the basic grid plate (4) and the spring sections (11) extending at least across the region between the adapter plate and the basic grid plate (4), **characterised in that** the full grid cassette comprises
- a film (20) located between the adapter plate (5) and the basic grid plate (4) and provided with holes through each of which one of the spring contact pins (3) passes, the width of the holes being less than a maximum diameter of the spring contact pins (3).

2. Full grid cassette according to claim 1,
**characterised in that**
the holes of the film (20) are designed as slots, the length of which is approximately equal to or slightly exceeds the maximum diameter of the spring contact pins.

3. Full grid cassette according to claim 1 or 2,
**characterised in that**
the film (20) is made of polyimide.

4. Full grid cassette according to any of claims 1 to 3,
**characterised in that**
the spring contact pins are made of spring wire.

5. Full grid cassette according to any of claims 1 to 4,
**characterised in that**
a taper is provided in the through holes (6, 7) of the basic grid plate (4) or the adapter plate (5), the through hole (5, 6) tapering towards the outside of the full grid cassette (2), and **in that** the spring contact pins (3) have a thickened section (13) located between the taper and the film (20).

6. Full grid cassette according to claim 5,
**characterised in that**
the taper is designed as an annular step.

7. Full grid cassette according to one of the claims 1 to 6,
**characterised in that**,
- a guide device (9) located between the adapter plate (5) and the basic grid plate (6) such that the adapter plate (4) and the basic grid plate (6) are movable relative to one another in the axial direction (10) of the spring contact pins (3) and have a play in the plane perpendicular to the axial direction (10) of the spring contact pins (3).

8. Full grid cassette according to any of claims 1 to 7,
**characterised in that**
the spring section (11) of the spring contact pins (3) extends across the region between the adapter plate (5) and the basic grid plate (4).

9. Full grid cassette according to any of claims 1 to 8,
**characterised in that**
the spring contact pins are arranged in a regular grid pattern corresponding to the basic grid.

10. full grid cassette, according to any of claims 1 to 9,
**characterised in that**
the spring contact pins (3) show a maximum diameter which is no more than 0.8 mm and the end winding of the wire at one end of the spring contact pins (3) is wound to a smaller radius than adjacent windings, so that the wire has an end which is disposed centrally relative to the adjacent windings and forms a central contact point.

11. Full grid cassette according to claim 10,
**characterised in that**
the wire is a spring wire and preferably
has a diameter of approximately 0.10 to 0.15 mm and 0.10 to 0.12 mm.

12. Unit comprising a full grid cassette according to one of the claims 1 to 11 and an adapter, for an apparatus for testing non-componented printed circuit boards, wherein the adapter (21) being designed for electrically connecting contact pins (3) of a full grid cassette (2) with contact points (36,37) of a printed circuit board (35)
**characterised in that**,
the adapter comprises test needles, which are secured from dropping out on just one side of the adapter and the full grid cassette is attached on the side of the adapter on which the test needles are not secured.

13. Unit according to claim 12,
**characterised in that**,
the adapter (21) comprises contact needles and/or contact pins as well as a plurality of guide plates (23, 25, 26, 28, 29, 30), wherein guide holes are formed through which the contact needles (31) and/or the contact pins (32) pass, wherein the contact pins (32) are designed for contacting plated-through holes (37) of the printed circuit boards to be tested with a scanning head which is significantly wider than the rest of the contact pin (32), and wherein the contact pin (32) has a locking projection (40) and the guide plate of the adapter (21) which faces the printed circuit board to be tested has a keyhole (41) designed such that the locking projection (40) can be passed through from the side of the printed circuit board (35) to be tested, and wherein, on the side remote from the printed circuit board to be tested, either a locking recess (42) is provided adjacent to the keyhole for the accommodation of the locking projection (40), or the keyhole has a region through which the locking projection (40) can be passed and which is slightly offset from the ideal position of the contact pin (32) and has a narrower region (44) which extends to the ideal position, so that the contact pin (32) adopts its ideal position guided by the further guide plates and the locking projection (40) comes to lie on the guide plate provided with the keyhole (41).

14. Unit according to claim 13,
**characterised in that**
the adapter is provided both with contact needles and with contact pins (32).

15. Unit according to claim 16 or 17,
**characterised in that**
the contact pins (32) are made of thin sheet metal.

## Revendications

1. Cassette à trame pleine surface pour un dispositif destiné à tester des cartes à circuits imprimés non garnies, ladite cassette à trame pleine surface (2) étant prévue pour connecter électriquement des points de contact d'une trame de base (1) avec une aiguille de contrôle respective d'un adaptateur (21), ladite cassette à trame pleine surface (2) comprenant
- des tiges de contact à ressort,
- une plaque de trame de base (4) agencée tournée vers la trame de base et une plaque adaptatrice (5) agencée tournée vers l'adaptateur (21), dans lesquelles sont ménagés des perçages traversants mutuellement alignés (6, 7) pour recevoir les tiges de contact à ressort (3), lesdites tiges de contact à ressort (3) étant respectivement réalisées d'un fil avec un tronçon de ressort (11) enroulé sous forme hélicoïdale, et étant agencées sans enveloppe dans les perçages traversants (6, 7) de la plaque adaptatrice (5) et de la plaque de trame de base (4), et les tronçons de ressort (11) s'étendent au moins sur la région entre la plaque adaptatrice et la plaque de trame de base (4),
**caractérisée en ce que** la cassette à trame pleine surface comprend
- un film (20), qui est agencé entre la plaque adaptatrice (5) et la plaque de trame de base (4) et présentant des trous à travers lesquels s'étend respectivement l'une des tiges de contact à ressort (3), dans laquelle la largeur des trous est plus petite qu'un diamètre maximum des tiges de contact à ressort (3).

2. Cassette à trame pleine surface selon la revendication 1,
**caractérisée en ce que** les trous du film (20) sont réalisés sous forme de trous oblongs dont la longueur correspond approximativement au diamètre maximum des tiges de contact à ressort ou est légèrement plus grande.

3. Cassette à trame pleine surface selon la revendication 1 ou 2,
**caractérisée en ce que** le film (20) est réalisé en polyimide.

4. Cassette à trame pleine surface selon l'une des revendications 1 à 3,
**caractérisée en ce que** les tiges de contact à ressort sont réalisées en fil-ressort.

5. Cassette à trame pleine surface selon l'une des revendications 1 à 4,
**caractérisée en ce que** dans les perçages traversants (6, 7) de la plaque de trame de base (4) ou de la plaque adaptatrice (5) est ménagé un rétrécissement de telle façon que le perçage traversant respectif (6, 7) va en se rétrécissant en direction de la face extérieure de la cassette à trame pleine surface (2), et **en ce que** les tiges de contact à ressort (3) comportent un emplacement épaissi (13) qui est situé entre le rétrécissement et le film (20).

6. Cassette à trame pleine surface selon la revendication 5,
**caractérisée en ce que** le rétrécissement est réalisé sous la forme d'un gradin annulaire (8).

7. Cassette à trame pleine surface selon l'une des revendications 1 à 6,
**caractérisée par**
un dispositif de guidage (9), qui est agencé entre la plaque adaptatrice (5) et la plaque de trame de base (6) de telle façon que la plaque adaptatrice (4) et la plaque de trame de base (6) sont déplaçables l'une par rapport à l'autre dans la direction axiale des tiges de contact à ressort (3), et présentent dans le plan transversal à la direction axiale (10) des tiges de contact à ressort (3) un jeu de mobilité.

8. Cassette à trame pleine surface selon l'une des revendications 1 à 7,
**caractérisée en ce que** le tronçon de ressort (11) des tiges de contact à ressort (3) s'étend sur la région entre la plaque adaptatrice (5) et la plaque de trame de base (4).

9. Cassette à trame pleine surface selon l'une des revendications 1 à 8,
**caractérisée en ce que** les tiges de contact à ressort sont agencées suivant une trame régulière qui correspond à la trame de base.

10. Cassette à trame pleine surface selon l'une des revendications 1 à 9,
**caractérisée en ce que** les tiges de contact à ressort (3) présentent un diamètre maximum qui n'est pas supérieur à 0,8 mm, et à une extrémité des tiges de contact à ressort (3) la spire terminale du fil est enroulée avec un rayon plus faible que les spires voisines, de sorte que le fil présente une extrémité qui est agencée au milieu par rapport aux spires voisines et qui forme un point de contact central.

11. Cassette à trame pleine surface selon la revendication 10,
**caractérisée en ce que** le fil est un fil-ressort et présente de préférence un diamètre d'environ 0,10 à 0,15 mm et en particulier 0,10 à 0,12 mm.

12. Unité comprenant une cassette à trame pleine surface selon l'une des revendications 1 à 11 et un adaptateur pour un dispositif destiné à tester des cartes à circuits imprimés non garnies, dans laquelle l'adaptateur (21) est prévu pour connecter électriquement des tiges de contact à ressort (3) d'une cassette à trame pleine surface (2) avec des points de contact (36, 37) d'une carte à circuits imprimés (35) à tester,
**caractérisée en ce que** l'adaptateur comporte des aiguilles de contrôle qui sont bloquées uniquement à l'encontre d'une chute sur un côté de l'adaptateur, et la cassette à trame pleine surface est posée sur le côté de l'adaptateur sur lequel les aiguilles de contrôle ne sont pas bloquées.

13. Unité selon la revendication 12,
**caractérisée en ce que** l'adaptateur (21) comprend des aiguilles et/ou des tiges de contact ainsi que plusieurs plaques de guidage (23, 25, 26, 28, 29, 30) dans lesquelles sont ménagés des perçages de guidage à travers lesquels s'étendent les aiguilles (31) et/ou les tiges (32) de contact, les tiges de contact (32) étant réalisées avec une tête de palpage pour venir en contact avec des trous métallisés de contact (37) des cartes à circuits imprimés à tester, ladite tête étant sensiblement plus large que le reste de la tige de contact (32), et la tige de contact (32) comporte une saillie de verrouillage (40) et la plaque de guidage de l'adaptateur (21), tournée vers la carte à circuit imprimé à tester, comporte un trou en forme de clé (41), lequel est réalisé de telle façon que la saillie de verrouillage (40) peut être passée à travers depuis le côté de la carte à circuits imprimés (35) à tester, et sur le côté détourné de la carte à circuits imprimés à tester il est prévu un logement de verrouillage (42) pour recevoir la saillie de verrouillage (40), agencé adjacent au trou en forme de clé, ou bien le trou en forme de clé (41) présente une région (43) à travers laquelle la saillie de verrouillage (40) peut être passée, et qui est décalée légèrement vis-à-vis de la position idéale de la tige de contact (32), et comporte une zone plus étroite (44) qui s'étend jusqu'à la position idéale, de sorte que la tige de contact (32) occupe sa position idéale grâce au guidage des autres plaques de guidage, et la saillie de verrouillage (4) est appliquée contre la plaque de guidage qui présente le trou en forme de clé (41).

14. Unité selon la revendication 13,
**caractérisée en ce que** l'adaptateur comprend à la fois des aiguilles de contact et des tiges de contact (32).

15. Unité selon la revendication 13 ou 14,
**caractérisée en ce que** les tiges de contact (32) sont réalisés à partir d'une tôle mince.
